## Europäisches Patentamt
## European Patent Office
## Office européen des brevets

(11) Veröffentlichungsnummer: **0 204 163**
**B1**

(12) **EUROPÄISCHE PATENTSCHRIFT**

(45) Veröffentlichungstag der Patentschrift:
31.01.90

(51) Int. Cl.⁴: **G 01 R 31/36**

(21) Anmeldenummer: **86106139.8**

(22) Anmeldetag: **05.05.86**

(54) **Messverfahren zur Bestimmung der Qualität einer Batterie.**

(30) Priorität: **08.05.85 DE 3516498**

(43) Veröffentlichungstag der Anmeldung:
**10.12.86 Patentblatt 86/50**

(45) Bekanntmachung des Hinweises auf die Patenterteilung:
**31.01.90 Patentblatt 90/5**

(84) Benannte Vertragsstaaten:
**AT BE CH DE FR GB IT LI NL SE**

(56) Entgegenhaltungen:
**DE-A- 2 008 889**
**DE-A- 2 812 874**
**DE-A- 3 108 844**
**DE-B- 2 610 536**
**DE-B- 2 842 817**
**DE-C- 1 771 317**

(73) Patentinhaber: **ACCUMULATORENFABRIK SONNENSCHEIN GMBH, Thiergarten Postfach 1180, D-6470 Büdingen 1 Oberhessen (DE)**

(72) Erfinder: **Tuphorn, Hans, Grünwaldweg 8, D-6470 Büdingen (DE)**

(74) Vertreter: **Baumann, Eduard, Dipl.-Phys., Postfach 1201 Sattlerstrasse 1, D-8011 Höhenkirchen/München (DE)**

## Beschreibung

Die Erfindung bezieht sich auf ein Meßverfahren zur Bestimmung der Qualität einer Batterie gemäß dem Oberbegriff des Anspruches 1.

Derartige Meßverfahren gewinnen zunehmend bei Notstromversorgungen aller Art an Bedeutung, wo es sich um Batterien handelt, die im wesentlichen ständig an ein Ladegerät und das mit dem Ladegerät verbundene Stromnetz angeschlossen sind. Diese Notstromaggregate haben die Aufgabe, bei einem störungsbedingten Netzausfall unverzüglich die Stromversorgung zu übernehmen, beispielsweise in Krankenhäusern, bei Elektrizitätswerken, bei Kraftwerken usw. Aus Sicherheitsgründen ist es erforderlich, diese Notstromversorgungs-Anlagen von Zeit zu Zeit zu überprüfen. Dies ist bisher nur ungenau oder mit erheblichem Zeitaufwand möglich, beispielsweise durch vollständiges Entladen und Wiederaufladen der Batterie.

Man spricht hier von einem Bereitschaftsparallelbetrieb von Notstrombatterien, da einerseits die Batterien im Normalfall mit dem Ladegerät verbunden und daher stets voll aufgeladen sind, andererseits parallel zum Stromnetz an den Verbraucherstromkreis schaltbar sind. Ein besonderes Problem ergibt sich bei modernen Batterien daraus, daß es sich hierbei um wartungsfreie, abgedichtete Batterien handelt, bei denen der Elektrolyt nicht mehr zugänglich ist, und somit auch die Messung der Elektrolytdichte keine Aussage mehr über den Batteriezustand geben kann. Die Möglichkeit einer Mess-Entladung der gesamten Batterie oder entsprechender Zellen durchzuführen, ist nicht nur umständlich und zeitraubend, sie stellt darüberhinaus auch ein Sicherheitsrisiko dar, da während dieser Messung die Notstromversorgung nicht gewährleistet ist.

In der DE-C-2 812 874 ist ein Verfahren zur Feststellung der Qualitätsanzeige von Batterien beschrieben. Hierbei wird der Momentan-Batteriespannungswert mit einem voreingestellten Minimalspannungswert verglichen und der Differenzwert als Maß für die Qualität der Batterie angezeigt.

Aus der DE-B-2 043 660 ist ein Verfahren bekannt, bei dem ebenfalls die Batterie mit einem definierten Belastungswiderstand belastet wird, die anliegende Spannung mit einem Meßinstrument gemessen, der gemessene Wert gespeichert, nach einer definierten Pause in einem zweiten Prüfvorgang die Leerlaufspannung mit dem Meßinstrument gemessen und mit dem gespeicherten Wert mit Hilfe einer logischen Schalteinrichtung verknüpft und verglichen wird, um zu einer Aussage über die Qualität der Batterie zu gelangen.

Ein ähnliches Verfahren ist aus der DE-B-2 610 536 bekannt. Hier werden Messungen mit einer bestimmten Hochstrombelastung nach bestimmten Zeitabständen durchgeführt und mit gespeicherten Referenzspannungen verglichen.

Aus der DE-C-3 213 516 ist ein Verfahren bekannt, bei dem ein Vergleich von Kennlinien mit Entladespannungen unter Berücksichtigung der Elektrolyt-Temperatur durchgeführt wird. Auch aus der DE-C-1 771 317 ist ein Verfahren bekannt, bei dem der Spannungsabfall gemessen und mit einem vorgegebenen Wert verglichen wird. Schließlich zeigt die DE-C-3 321 814 eine Batterieanzeige-Vorrichtung mit einem Meßwiderstand, einem Schalter, einem Temperaturfühler, einer Auswerteeinheit und einem Vergleich mit einer gespeicherten Spannungsabfallfunktion.

Alle bekannten Meßverfahren berücksichtigen nicht in ausreichendem Maße die Tatsache, daß sich der Spannungsabfall an den Batterieklemmen zum einen aus dem Abfall aufgrund des Innenwiderstandes der Batterie zusammensetzt, der unmittelbar nach dem Anklemmen eines Meßwiderstandes erfolgt, zum anderen aus der Polarisation, die, abhängig von der Reaktionsgeschwindigkeit der aktiven Elektrodenmassen, den zeitlichen Spannungsverlauf während eines längeren Stromflusses beeinflußt.

Es stellte sich heraus, daß sich dieser Einfluß im Laufe der Lebensdauer einer Batterie deutlich verändert, so daß die Polarisationsspannung zur Ermittlung der Qualität einer Batterie dienen kann.

Der Erfindung liegt die Aufgabe zugrunde, die Nachteile des Standes der Technik zu vermeiden und ein Meßverfahren gemäß dem Oberbegriff des Anspruches 1 so auszugestalten, daß der durch den Innenwiderstand der Batterie beziehungsweise einer Batteriezelle bedingte Spannungsabfall eliminiert und im wesentlichen ledigkeit der durch die Polarisationsspannung bedingte Spannungsabfall zur Überprüfung der Qualität einer Batterie herangezogen wird.

Die Aufgabe wird erfindungsgemäß durch die Merkmale des Kennzeichens des Anspruches 1 gelöst. Weitere Ausgestaltungen der Erfindung sind in den abhängigen Ansprüchen unter Schutz gestellt.

Der Erfindung liegt die Idee zugrunde, daß der durch den Innenwiderstand der Batterie bedingte Spannungsabfall unmittelbar nach Anschluß eines Meßwiderstandes auftritt, während der nachfolgende Spannungsabfall im wesentlichen durch die Polarisationsspannung an den Klemmen bedingt ist. Diese Polarisationsspannung ändert sich stark im Laufe der Lebensdauer einer Batterie beziehungsweise aufgrund der auftretenden Belastung. Führt man somit die erste Spannungsmessung erst nach dem Anschließen des Meßwiderstandes durch, so erhält man einen Wert, für den Spannungsabfall, der den durch den Innenwiderstand von Batterie oder Batteriezelle bedingten Spannungsabfall nicht mehr enthält, sondern im wesentlichen der Polarisationsspannung entspricht. Dieser Wert bildet den Ausgangswert für wenigstens eine weitere Spannungsabfallmessung. Vergleicht man die Werte einer alten Batterie mit den Werten für die neue Batterie, so lassen sich bereits aus zwei Messungen Aussagen über den Qualitätszustand der gemessenen Batterie machen. Wiederholt man diese Messungen in bestimmten Abständen bei weiterhin angeschlossenem Meßwiderstand, beispielsweise für eine Gesamtzeitdauer von 30 Minuten, wobei man eine bestimmte Kapazität entnimmt, so erhält man einen Spannungs-Abfallverlauf, der eine noch genauere Aussage über die aufgebaute Polarisationsspannung und damit über den Qualitätszustand ermöglicht. Je stärker der Spannungsabfall ist, umso schlechter ist die Batteriequalität.

Es stellte sich heraus, daß die polarisationsbedingte Änderung des Spannungsabfalles zuverlässiger und aussagekräftiger ist, als die Änderung des Innenwiderstandes, der bei bisherigen Meßverfahren die Meßwerte stark beeinflußt. Der durch die Polarisation bedingte Spannungsabfall ist von der Reversibilität des Ladebeziehungsweise Entladevorganges abhängig und kann in einer längeren zeitlichen Messung gesondert ermittelt werden. Zweckmäßigerweise sollte die Batterie vor der Messung ca. 10 bis 15 Minuten vom Ladegerät getrennt werden, damit sich eine Ruhespannung einstellen kann. Es ist jedoch auch möglich, die voll geladene Batterie ohne angeschalteten Verbraucher unmittelbar der Messung zu unterziehen. Die Meßströme sind so zu wählen, daß eine deutliche Änderung des Polarisationszustandes der Batterie stattfindet. Da wie die — hier eliminierten — Innenwiderstandswerte auch die Polarisationsspannungen temperaturabhängig sind, muß bei stärkerer Abweichung der Batterietemperatur von der Raumtemperatur eine Temperaturkompensation stattfinden, wobei entweder die gespeicherten Bezugsmeßwerte oder, vorzugsweise, die momentanen Meßwerte entsprechend korrigiert werden.

Anstatt die Batterie in definierter Weise zu entladen, läßt sich im wesentlichen dasselbe Ergebnis durch eine definierte Aufladung erzielen, selbst wenn die Batterie an sich voll aufgeladen ist, wobei eine Überladung und eine Gasbildung eintritt. Noch genauere und zuverlässigere Ergebnisse erzielt man, wenn Entlade-, Auflade- und Meßvorgänge in definierter Weise kombiniert werden. Ein bevorzugtes Ausführungsbeispiel ermöglicht es auch, jede Batterie individuell einzueichen, indem zunächst bei der neuen Batterie die Werte in einen Bezugswertspeicher eingegeben und dann von Zeit zu Zeit zur Überprüfung der Qualität mit den Momentanwerten verglichen werden. Bei Auftreten bestimmter Differenzen beziehungsweise Differenz-Spannungsverläufen kann die entsprechende Batterie rechtzeitig und ohne großen Prüfaufwand durch eine neue Batterie ersetzt werden, ohne daß irgendwelche Risiken in der Zwischenzeit auftreten. Im übrigen können die errechneten Daten auch unmittelbar angezeigt und über eine Datenfernübertragung an zentrale Kontrollstellen übertragen werden.

Ein Ausführungsbeispiel der Erfindung ist in der Zeichnung dargestellt.

Es zeigt:

Fig. 1 einen schematischen Schaltungsaufbau der Erfindung,

Fig. 2 einen typischen Spannungsabfall-Verlauf einer alten sowie einer neuen Batterie.

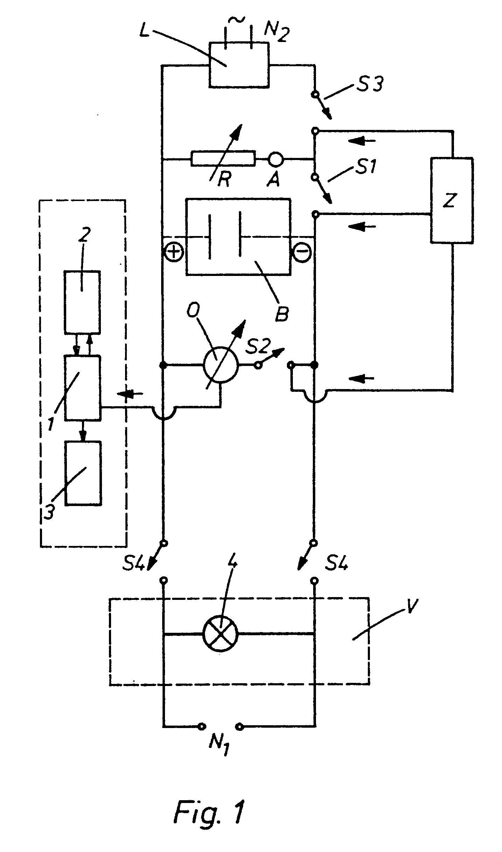

Gemäß Fig. 1 ist die Batterie B zum einen an ein Ladegerät L, das mit dem Stromnetz N2 verbunden ist, zum anderen an einen Verbraucherstromkreis V mit einem Verbraucher 4 angeschlossen, an den sie im Bedarfsfall beziehungsweise Notfall über einen Doppelschalter S4 angeschlossen werden kann. Der Verbraucherstromkreis V ist normalerweise an das Netz N1 angeschlossen. Dieser Netzanschluß wird im Notfall durch das Anklemmen des Notstromaggregates mit der Batterie B ersetzt.

Der eigentliche Meßstromkreis besteht aus einem variablen Meßwiderstand R, in der Regel aus einem dahintergeschalteten Strommesser A zur Widerstandsregelung sowie einem ersten Schalter S1 und ist mit den beiden Klemmen der Batterie B oder einer oder mehrerer Zellen einer derartigen Batterie verbunden. Ebenfalls ist mit diesen Batterieklemmen über einen Schalter S3 ein Ladegerät L verbunden, dessen Primärseite an ein Stromnetz N2 angeschlossen ist; schließlich ist über einen zweiten Schalter S2 ein im wesentlichen trägheitsloses Spannungsmeßgerät in Form eines Oszillographen angeschlossen.

Aus Fig. 1 ist weiterhin eine Bezugsspannungsquelle 2 zu erkennen, welche vorgegebene beziehungsweise voreingestellte Bezugssignale, die einer neuen Batterie entsprechen, an einem Vergleicher 1 liefert, dem ebenfalls die Momentan-Spannungsmeßwerte des Spannungsmeßgerätes O zugeführt werden. Die Differenz dieser Werte liefert eine unmittelbare Aussage für den Qualitätszustand einer Batterie, der nach Auswertung durch einen entsprechenden Rechner und eine Anzeigeeinrichtung 3 unmittelbar angezeigt werden kann. Bei dem Spannungsgerät O handelt es sich vorzugsweise um einen Oszillographen, der im wesentlichen trägheitslos funktioniert und somit imstande ist, den unmittelbar nach dem Anschalten des Meßwiderstandes beziehungsweise im umgekehrten Fall nach dem Anschalten des Ladegerätes auftretenden starken Spannungsabfall beziehungsweise die auftretende starke Spannungsüberhöhung von dem nachfolgenden langsameren Spannungsabfall beziehungsweise der langsameren Spannungserhöhung zu trennen.

Schließlich ist aus Fig. 1 noch ein Zeitglied Z zu erkennen, das sowohl mit dem ersten Schalter S1 als auch mit dem zweiten Schalter S2 verbunden ist. Dieses Zeitglied kann den zeitlichen Ablauf der Verbindung und Trennung der Batterieklemmen mit dem Ladegerät, dem Meßwiderstand und dem Spannungsmeßgerät O nach einem zweckmäßigen Programm steuern, das für verschiedene Batterietypen unterschiedlich sein kann. Bei dem Meßwiderstand R handelt es sich um einen Spezialwiderstand, der unabhängig von der angelegten Netzspannung den gleichen Strom durchläßt, und der durch das Strommeßgerät A entsprechend gesteuert wird.

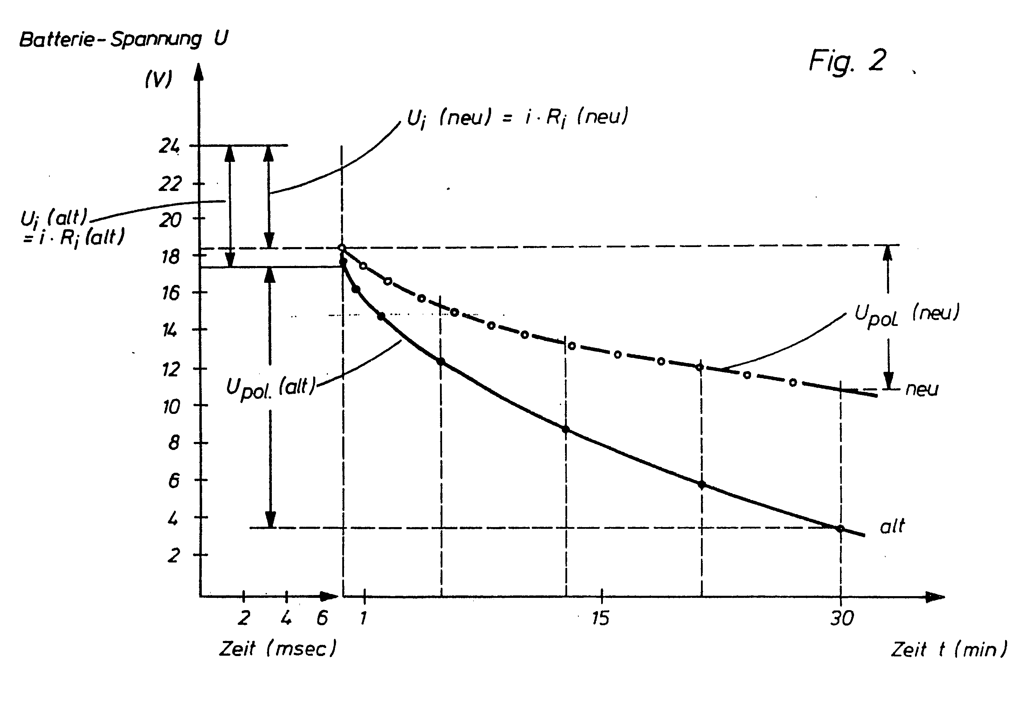

Fig. 2 zeigt den Verlauf des Spannungsabfalles nach Anlegen des Meßwiderstandes an die Batterieklemmen. Es wird festgestellt, daß zunächst ein sehr starker Spannungsabfall $U_i$ erfolgt, und zwar innerhalb von Sekundenbruchteilen, der dem Innenwiderstand $R_i$ der Batterie entspricht, und daß danach ein allmählicher Abfall der Klemmenspannung folgt, welcher der an den Klemmen aufgebauten Polarisationsspannung entspricht.

Aus Fig. 2 geht hervor, daß der durch den Innenwiderstand der Batterie bedingte erste Spannungsabfall für eine alte und eine neue Batterie ziemlich gleich ist, wobei er lediglich im Falle einer alten Batterie noch etwas höher ist. Die darauf folgenden Werte gehen jedoch für eine alte Batterie und eine neue Batterie deutlich auseinander. Ein Vergleich der Meßwerte für eine neue Batterie mit den entsprechenden Werten einer alten verbrauchten Batterie ermöglicht somit eine gesicherte Aussage über die Batteriequalität. In Fig. 2 ist die Spannung U in Volt oder V angegeben, Zeit t in sec., i bezeichnet den Strom, $R_i$ den Innenwiderstand der Batterie, Pol. bezeichnet Polarisations-Vorgänge, insbesondere einen Spannungsabfall, der durch Polarisation hervorgerufen wird.

Das geschilderte Meßverfahren ist einfach, zuverlässig und in kürzester Zeit sowie regelmäßig durchzuführen.

**Patentansprüche**

1. Meßverfahren zur Bestimmung der Qualität einer Batterie, vorzugsweise eines Bleiakkumulators, wobei die Endpole ( + , −) der Batterie (B) im Normalfall mit einem Ladegerät (L) und im Bedarfsfall (Notfall) mit einem Verbraucherstromkreis (V) verbunden werden, und wobei der Spannungsabfall der Batterie gemessen wird, der sich bei Stromfluß über einen Konstantstrom-Widerstand (R) ergibt, der unabhängig von der anliegenden Spannung einen konstanten Strom liefert, oder wobei die Spannungserhöhung nach Anschluß des Ladegerätes gemessen wird, wenn die Pole der Batterie oder einer Batterie-Zelle durch den Widerstand (R) oder das Ladegerät überbrückt werden, dadurch gekennzeichnet,

— daß unmittelbar nach dem Anschließen des Konstantstrom-Widerstandes (R) oder des Ladegerätes an die Endpole ( + , −) oder an Zellpole der Batterie (B) durch ein im wesentlichen trägheitsloses Spannungsmeßgerät (O) ein erster Spannungswert unmittelbar nach dem durch den Innenwiderstand (Ri) der Batterie bzw. Zelle bedingten Spannungsabfall gemessen wird, der als Ausgangswert für den nachfolgenden, Polarisations-bedingten Spannungsabfall dient, und daß danach während eines längeren Stromflusses, beispielsweise von 30 Minuten weitere Spannungs-Meßwerte ermittelt werden,

— daß die vom Spannungsmeßgerät (O) gelieferten Meßwerte der Batterie-Klemmenspannung einem Vergleichsstromkreis (1) zugeführt werden, wo sie mit in einer Bezugsspannungsquelle (2) gespeicherten Bezugswerten, die einer neuen Batterie entsprechen, verglichen werden, daß die ermittelten Differenzsignale in einem Rechner ausgewertet werden, und daß entsprechende Signale eine Anzeigevorrichtung (3) steuern, um eine Anzeige der Qualität der untersuchten Batterie zu liefern.

2. Verfahren nach Anspruch 1, dadurch gekennzeichnet, daß die Zeitverzögerung zwischen Anschließen des Konstantstrom-Widerstandes (R) und der ersten Spannungs-Messung zwischen 0,01 ms und 5 ms liegt, abhängig von Batterietyp und Messanordnung.

3. Verfahren nach Anspruch 1 oder Anspruch 2, dadurch gekennzeichnet, daß als Spannungsmeßgerät ein Oszillograph (O) verwendet wird.

4. Verfahren nach einem der Ansprüche 1 bis 3, dadurch gekennzeichnet, daß unmittelbar vor dem Meßvorgang das Ladegerät über einen dritten Schalter (S3) von der Batterie getrennt und der Konstantstrom-Widerstand (R) angeschaltet wird, der vorzugsweise mit einem Strommeßgerät zum Regeln des Konstantstromwiderstandes in Reihe geschaltet ist.

5. Verfahren nach einem der Ansprüche 1 bis 4, dadurch gekennzeichnet, daß im Anschluß an die erste Messung in regelmäßigen Zeitabständen für eine Gesamtzeit von etwa 0,5 sec - 60 min., vorzugsweise zwischen 0,5 sec und 30 sec, weitere Messungen folgen.

6. Verfahren nach einem der Ansprüche 1 bis 5, dadurch gekennzeichnet, daß ein Zeitschaltglied (Z) eingesetzt wird, das mit einem ersten Schalter (S1) zwischen Batterieklemmen und Konstantstrom-Widerstand (R) sowie mit einem zweiten Schalter (S2) zwischen Batterieklemmen und Spannungsmeßgerät (O) in Verbindung steht und zuerst den ersten Schalter und unmittelbar danach den zweiten Schalter schließt.

7. Verfahren nach einem der Ansprüche 1 bis 6, dadurch gekennzeichnet, daß die Bezugswerte in der Bezugsspannungsquelle (2) durch Durchführung einer ersten Spannungsverlaufs-Messung und entsprechende Einspeicherung mit der neuen Batterie ermittelt werden.

8. Verfahren nach einem der Ansprüche 1 bis 7, dadurch gekennzeichnet, daß das Ladegerät zuerst von den Batterieklemmen abgetrennt wird, dann an die Batterieklemmen ( + , −) angeschaltet und ermittelbar darauf eine erste Spannungserhöhung und gegebenenfalls in gleichmäßigen Abständen weitere Spannungserhöhungen durch das im wesentlichen trägheitslose Spannungsmeßgerät (O) gemessen werden, um eine Aussage über die Qualität der untersuchten Batterie zu ermöglichen.

9. Verfahren nach einem der Ansprüche 1 bis 8, dadurch gekennzeichnet, daß Entlade- und Aufladevorgänge sowie Spannungsmessungen in definierter Weise miteinander kombiniert werden, wobei die gemessenen Werte nach entsprechender Auswertung, vorzugsweise mit Hilfe eines Rechners, eine genauere Aussage über den Qualitätszustand der untersuchten Batterie ermöglichen, wobei das Ladegerät (L) vorzugsweise zuerst von den Batterieklemmen abgetrennt wird, dann mit dem Konstantstromwiderstand verbunden wird, unmittelbar danach mit einem im wesentlichen trägheitslosen Spannungs-Meßgerät (O) eine erste Spannungsabfallmessung erfolgt, der weitere Messungen folgen, wobei danach der Konstantstromwiderstand (R) von den Batterie- oder Zellklemmen abgetrennt, anschließend das Ladegerät (L) angeschaltet wird und unmittelbar danach eine erste Spannungserhöhungs-Messung erfolgt, der weitere Messungen folgen, und wobei bei der anschließenden Auswertung aus den beiden Meßreihen ein Mittelwert gebildet wird.

10. Verfahren nach einem der Ansprüche 1 bis 9, dadurch gekennzeichnet, daß die Entlade- und Aufladevorgänge bei einem Stromfluß (in Ampère) durchgeführt werden, dessen Wert zwischen 10% und 200% der Batteriekapazität (in Ampèrestunden) liegt.

11. Verfahren nach einem der Ansprüche 1 bis 11, dadurch gekennzeichnet, daß die Entlade- und Aufladevorgänge mehrmals wechseln und zwischen 0,5 bis 30 Sekunden dauern.

12. Verfahren nach einem der Ansprüche 1 bis 11, dadurch gekennzeichnet, daß die Kapazitätentnahme bei der gesamten Messung zwischen 0,1% und 5% der Nennkapazität der Batterie (B) bzw. Batteriezelle liegt.

13. Verfahren nach einem der Ansprüche 1 bis 12, dadurch gekennzeichnet, daß ein Temperaturfühler vorgesehen ist, der die in der Bezugsquelle (2) gespeicherten Werte oder die Meßwerte entsprechend der Umgebungstemperatur korrigiert.

## Claims

1. Measuring method for determining the quality of a battery, preferably of a lead storage battery, in which the terminals ( + , −) of the battery (B) normally are connected to a charging set (L) and in case of emergency are connected to a load circuit (V), and in which the voltage drop of the battery is measured which results upon current flow through a constant-current resistor (R) which provides a constant current irrespective of the applied voltage, or in which the voltage increase upon connection of the charging set is measured when the terminals of the battery or of a battery cell are bridged by the resistance (R) or the charging set, respectively, characterized in

— that immediately upon connection of the constant-current resistor (R) or the charging set to the terminals ( + , −) or to cell terminals of the battery (B) a substantially inertialess voltmeter (O) measures a first voltage level immediately following the voltage drop due to the internal resistance ($R_i$) of the battery or cell, said voltage level serving as a basic value for the subsequent voltage drop due to polarization, and that thereafter further voltage levels are measured during a prolonged flow of current, for example for 30 minutes,

— that the measured values of the battery terminal voltage outputted by the voltmeter (O) are applied to a comparator circuit (1) for comparison with reference values which are stored in a reference voltage source (2) and correspond to a fresh battery,

— that the resulting difference signals are processed in a processor, and

— that corresponding signals control a display means (3) for providing an indication of the quality of the tested battery.

2. Method as claimed in claim 1, characterized in that the time delay between coupling of the constant-current resistor (R) and the first voltage measurement is between 0.01 and 5 ms depending on the type of battery and the measuring system.

3. Method as claimed in claim 1 or claim 2, characterized in that an oscillograph (O) is used as voltmeter.

4. Methode as claimed in any one of the claims 1 to 3, characterized in that immediately prior to the measuring operation the charging set is disconnected from the battery through a third switch (S3) and the constant-current resistor (R) is connected, the latter being preferably connected in series with an ammeter for regulating the constant-current resistor.

5. Method as claimed in any one of the claims 1 to 4, characterized in that subsequent to the first measurement, further measurements are made at regular time intervals over a period of about 0.5 s to 60 min, preferably between 0.5 s and 30 s.

6. Method as claimed in any one of the claims 1 to 5, characterized in that a timer (Z) is used which is connected to a first switch (S1) provided between battery terminals and constant-current resistor (R) and to a second switch (S2) provided between battery terminals and voltmeter (O), said timer closing first said first switch and immediately thereafter closing said second switch.

7. Method as claimed in any one of the claims 1 to 6, characterized in that the reference values stored in the reference voltage source (2) are determined by subjecting the fresh battery to a first voltage characteristics measurement and corresponding storage.

8. Method as claimed in any one of the claims 1 to 7, characterized in that the charging set is initially disconnected from the battery terminals and then connected to the battery terminals ( + , −) and immediately thereafter a first voltage increase and, if applicable, at regular intervals further voltage increases are measured by the substantially inertialess voltmeter (O) so as to obtain information about the quality of the tested battery.

9. Method as claimed in any one of the claims 1 to 8, characterized in that discharging and charging operations as well as voltage measuring operations are combined in a defined way, the measured values after corresponding processing, preferably by means of a processor, providing more precise information about the quality status of the tested battery, in which the charging set (L) preferably is first disconnected from the battery terminals and is then connected to the constant-current resistor, and immediately thereafter a first voltage drop is measured with a substantially inertialess voltmeter (O), whereafter further measurements follow, the constant-current resistor (R) being thereafter disconnected from the battery or cell terminals, and thereafter the charging set (L) is connected and immediately thereafter a first measurement of a voltage increase is performed which is followed by further measurements, the subsequent processing forming an average value from both series of measurements.

10. Method as claimed in any one of the claims 1 to 9, characterized in that the discharging and charging operations are performed while a current (in terms of amperes) is flowing whose value is between 10% and 200% of the battery capacity (in terms of ampere hours).

11. Method as claimed in any one of the claims 1 to 11, characterized in that the discharging and charging operations alternate several times and last between 0.5 and 30 seconds.

12. Method as claimed in any one of the claims 1 to 11, characterized in that the capacity output for the entire measurement is between 0,1 % and 5% of the nominal capacity of the battery (B) or battery cell, respectively.

13. Method as claimed in any one of the claims 1 to 12, characterized in that a temperature sensor is provided for correcting either the values stored in the reference source (2) or the measured values in response to ambient temperature.

## Revendications

1. Méthode de mesure pour la détermination de la qualité d'une batterie, de préférence un accumulateur à plomb, les pôles ( +, −) de la batterie (B) étant normalement raccordés à un chargeur (L) et en cas de besoin (urgence) à un réseau utilisateur (V), consistant à mesurer la chute de tension de la batterie se produisant à la décharge d'un flux de courant traversant une résistance à courant constant (R) fournissant uñ courant constant indépendamment de la tension appliquée, ou bien consistant à mesurer l'augmentation de tension consécutive à la connexion d'un chargeur lorsque les pôles de la batterie ou d'une cellule de celle-ci sont pontés par une résistance (R) ou par le chargeur, caractérisée en ce que

— immédiatement après la connexion de la résistance à courant constant (R) ou du chargeur aux pôles ( +, −) de la batterie (B) ou aux pôles de cellules de celle-ci, on mesure une première valeur de tension à l'aide d'un voltmètre largement exempt d'inertie immédiatement après la chute de tension due à la résistance intérieure de la batterie ou de sa cellule, cette première valeur servant de référence à la diminution ultérieure de la tension due à la polarisation, et que ensuite, lors du passage d'un flux de courant de plus longue durée, p. ex. de 30 minutes, on mesure la tension encore un certain nombre de fois.

— les valeurs de la tension aux bornes de la batterie mesurées à l'aide du voltmètre (O) sont transmises à un circuit électrique de comparaison (1) où ils sont comparés avec des valeurs de référence mémorisées dans une source de tension de référence (2) correspondant à une batterie neuve, que les signaux de différence établis sont exploités par un ordinateur, et que les signaux correspondants commandent un dispositif d'affichage (3) afin de fournir un affichage de la qualité de la batterie examinée.

2. Méthode selon la revendication 1, caractérisée en ce que la temporisation entre la connexion de la résistance à courant constant (R) et la première mesure de la tension est comprise entre 0,01 ms et 5 ms, selon la type de batterie et la configuration de mesure.

3. Méthode selon la revendication 1 ou 2, caractérisée en ce que le voltmètre utilisé est un oscillographe.

4. Méthode selon l'une des revendications 1 à 3, caractérisée en ce que, immédiatement avant la mesure, au moyen d'un troisième interrupteur (S3), on déconnecte la batterie du chargeur et on connecte la résistance à courant constant (R) qui est de préférence branchée en série avec un ampèremètre destiné à régler la résistance à courant constant.

5. Méthode selon l'une des revendications 1 à 4, caractérisée en ce que la prèmière mesure est suivie par d'autres mesures effectuées en intervalles réguliers, de préférence compris entre 0,5 sec et 30 sec., sur une durée totale d'environ 0,5 sec à 60 min.

6. Méthode selon l'une des revendications 1 à 5, caractérisée en ce que l'on interconnecte un relais de temporisation (Z) raccordé à un premier interrupteur (S1) branché entre les bornes de la batterie et la résistance à courant constant (R) et à un deuxième interrupteur (S2) branché entre les bornes de la batterie et le voltmètre (O), et que l'on ferme d'abord le premier interrupteur et aussitôt après le deuxième.

7. Méthode selon l'une des revendications 1 à 6, caractérisée en ce que les valeurs de référence de la source de tension de référence (2) sont établies en mesurant l'évolution de la tension sur la batterie neuve et en mémorisant les valeurs obtenues.

8. Méthode selon l'une des revendications 1 à 7, caractérisés en ce qu'en premier, le chargeur est déconnecté des bornes de la batterie, puis reconnecté sur les bornes de la batterie ( +, −), puis qu'aussitôt après on mesure en intervalles réguliers une première augmentation de tension et le cas échéant d'autres augmentations de tension à l'aide du voltmètre largement exempt d'inertie (O), afin de permettre l'évaluation de la qualité de la batterie.

9. Méthode selon l'une des revendications 1 à 8, caractérisée en ce que les processus de décharge et de recharge et les mesures de tension sont combinés entre eux d'une manière définie, les valeurs mesurées permettant après exploitation appropriée, de préférence à l'aide d'un ordinateur, une évaluation plus précise de la qualité de la batterie examinée, le chargeur (L) étant de préférence déconnecté en premier des bornes de la batterie que l'on raccorde à la résistance à courant constant, puis que l'on procède immédiatement après à une première mesure de la chute de tension au moyen d'un voltmètre largement exempt d'inertie (O), laquelle est suivie par d'autres mesures, puis que l'on déconnecte la résistance à courant constant (R) des bornes de la batterie ou des cellules, puis que l'on connecte le chargeur (L) et que l'on procède immédiatement après à une première mesure d'augmentation de tension suivie par d'autres mesures, et qu'au cours de l'exploitation des deux séries de mesures, on calcule une moyenne.

10. Méthode selon l'une des revendications 1 à 9, caractérisée en ce que les processus de décharge et de recharge sont effectués avec un flux de courant (en Ampère) dont la valeur est comprise entre 10% et 200% de la capacité de la batterie (en Ampères-heures).

11. Méthode selon l'une des revendications 1 à 10, caractérisée en ce que les processus de décharge et de recharge alternent plusieurs fois et durent entre 0,5 et 30 secondes.

12. Méthode selon l'une des revendications 1 à 11, caractérisée en ce que le prélèvement de capacité au cours de l'ensemble des mesures est compris entre 0,1% et 5% de la capacité nominale de la batterie (B) ou de la cellule de celle-ci.

13. Méthode selon l'une des revendications 1 à 12, caractérisée en ce qu'est prévu en thermomètre qui corrige les valeurs mémorisées dans la source de référence (2) en fonction de la température ambiante.

*Fig. 1*

Fig. 2

Batterie-Spannung U

(V)

$U_i$ (neu) $= i \cdot R_i$ (neu)

$U_i$ (alt) $= i \cdot R_i$ (alt)

$U_{pol.}$ (alt)

$U_{pol}$ (neu)

neu

alt

Zeit (msec)

Zeit t (min)

EP 0 204 163 B1